Europäisches Patentamt

European Patent Office

Office européen des brevets

(19)

(11) Veröffentlichungsnummer: **0 010 633**
**B1**

(12) **EUROPÄISCHE PATENTSCHRIFT**

(45) Veröffentlichungstag der Patentschrift: **13.10.82**

(21) Anmeldenummer: **79103770.8**

(22) Anmeldetag: **03.10.79**

(51) Int. Cl.³: **H 01 L 21/225,**
**H 01 L 21/263**

(54) Verfahren zur Herstellung sehr schmaler Dosierungsgebiete in einem Halbleiterkörper sowie Verwendung dieses Verfahrens bei der Erzeugung von voneinander isolierten Halbleiterkörperbereichen, Bipolar-Halbleiteranordnungen, integrieten Injektionslogikschaltungen und doppelt diffundierten FET-Halbleiteranordnungen.

(30) Priorität: **03.11.78 US 957599**

(43) Veröffentlichungstag der Anmeldung:
**14.05.80 Patentblatt 80/10**

(45) Bekanntmachung des Hinweises auf die Patenterteilung:
**13.10.82 Patentblatt 82/41**

(84) Benannte Vertragsstaaten:
**DE FR GB**

(56) Entgegenhaltungen:
**DE - A - 2 818 090**

**IBM TECHNICAL DISCLOSURE BULLETIN, Band 21, Heft 9, Februar 1979 New York J. L. DEINES et al. "Process for realization of submicron geometries" Seiten 3628 bis 3629**
**SOLID STATE TECHNOLOGY, Band 19, Heft 4, April 1976 Port Washington PER G. Glöersen "Masking for ion beam etching" Seiten 68 bis 73**

(73) Patentinhaber: **International Business Machines Corporation**
**Armonk, N.Y. 10504 (US)**

(72) Erfinder: **Ho, Irving Tze**
**2 High Point Drive**
**Poughkeepsie, New York, 12 603 (US)**
Erfinder: **Riseman, Jacob**
**38 Barnard Avenue**
**Poughkeepsie, New York, 12 603 (US)**

(74) Vertreter: **Kreidler, Eva-Maria, Dr. rer. nat.**
**Schönaicher Strasse 220**
**D-7030 Böblingen (DE)**

Courier Press, Leamington Spa, England.

# Verfahren zur Herstellung sehr schmaler Dosierungsgebiete in einem Halbleiterkörper sowie Verwendung dieses Verfahrens bei der Erzeugung von voneinander isolierten Halbleiterkörperbereichen, Bipoler-diffundierten FET- Halbleiteranordnungen Halbleiteranordnungen, integrieten Injektionslogikschaltungen und doppelt

Die Erfindung bezieht sich auf Verfahren zur Herstellung sehr schmaler Dotierungsgebiete in einem Halbleiterkörper unter Ausnutzung einer Diffusion der jeweiligen Dotierstoffe aus zugehörigen Quellschichtbereichen sowie die verwendung dieses Verfahrens bei der Erzeugung von voneinander isolierten Halbleiterkörperbereichen, Bipolar Halbleiteranordnungen, integrieten Injektionslogikschaltungen und doppelt diffundierten FET-Halbleiteranordnungen.

Die Komplexität integrierter Silicium-Schaltkreise hat in den letzten zehn Jahren erheblich zugenommen. Mit zunehmen-der Erschließung von Anwendungsgebieten für Mikroprozessoren und Kleinrechner ergab sich ein entsprechend zunehmendes Bedürfnis für eine gesteigerte Komplexität, höhere Schaltgeschwindigkeit und kleinere Abmessungen solcher integrierter Schaltkreise. Im Rahmen der Halbleiterprozesse erlaubt in erster Linie die Lithographie eine Steigerung der Komplexität der integrierten Schaltkreise. In den letzten Jahren konnten lediglich mäßige Verringerungen der erzielbaren (minimalen) Linienbreite integrierter Strukturen erreicht werden. Die hohen Steigerungen der Integrationsdichte wurden in erster Linie durch eine Senkung der photolithographischen Defektdichten erzielt. Dabei erfolgte eine allmähliche Verringerung der Linienbreiten von etwa 5 bis 10 $\mu$m auf heute etwa 3 bis 5 $\mu$m. Nahezu ausschließlich wurde ferner bisher Licht im Rahmen der Lithographieprozesse eingesetzt. Inzwischen machen jedoch die Grenzen der optischen Auflösung weitere Fortschritte zunehmend schwieriger. Für die zukünftig erforderlichen gesteigerten Packungsdichten setzt man daher heute zunehmend auf eine Lithographietechnik, die ohne Lichtstrahlung auskommt, insbesondere auf Elektronen- und Röntgenstrahlbelichtungsverfahren. Problem dieser Art und mögliche Lösungen dafür werden eingehender behandelt in dem Artikel von B. L. Critchlow mit dem Titel "High Speed Mosfet circuits Using Advanced Lithography", veröffentlicht in der Zeitschrift Computer, Band 9, Nr. 2, Februar 1976, Seiten 31 bis 37. In diesem Artikel kommen insbesonders die erheblichen Kosten für die erforderliche Apparatur sowie die Komplexität der Röntgen- und Elektronenstrahllithographie zum Ausdruck. Bisher besteht jedoch die Auffassung, daß diese Techniken die einzigen Alternativen für die optische Projektionsbelichtung für derart hochkomplexe integrierte Schaltkreise der zukünftig benötigten Art darstellen.

Darüber hinaus gab es weitere Bemühungen, sehr schmalle Linienbreiten im Bereich von 1 $\mu$m oder darunter durch Ausweitung der standardmäßigen photolithographischen Verfahren unter Vermeidung derart kostenträchtiger und komplexer Techniken wie Elektronen- oder Röntgenstrahllithographie zu erzielen. Ein möglicher Lösungsweg ist beispielsweise in der Veröffentlichung im IBM Technical Disclosure Bulletin, Vol. 19, No. 6, November 1976, Seiten 2057/2058 unter dem Titel "Narrow Line Widths Masking Method" beschrieben. Das dort behandelte Verfahren macht von porösem Silicium und einem zugehörigen Oxidationsprozess Gebrauch. Ein anderes Verfahren ist in der Veröffentlichung im IBM Technical Disclosure Bulletin Vol. 20, No. 4, September 1977 auf den Seiten 1376 bis 1378 beschrieben. Dort werden polykristalline Maskierungsschichten aus Silicium benutzt, wobei die Maskenausbildung unter Einsatz einer Zwischenmaskierung aus einem oxidationshemmenden Material, z.B. im Fall von polykristallinem Silicium aus Siliciumnitrid, erfolgt. Mit diesem Verfahren lassen sich Linienbreiten unterhalb 2 $\mu$m erzielen.

Ferner steht in der Technik des Plasma- oder reaktiven Ionenätzens eine zum Ätzen von Metallen, halbleitenden und dieletrischen Materialen für integrierte Schaltkreise entwickeite Technik mit guten Eigenschaften zur Verfügung. Insbesondere läßt sich mit dem reaktiven Ionenätzen ein anisotropisches Ätzen durchführen, mit dem hohe sog. Aspektverhältnisse erzielbar sind, d.h. die Ätzrate in vertikaler Richtung ist erheblich stärker ausgeprägt als die in horizontaler Richtung. Für die Prozeßdurchführung wird ein Plasma bzw. ionisiertes Gas benötigt, für das eine Vielzahl von hoch-reaktiven Bestandteilen, z.B. Ionen, freie Elektronen und freie Radikale, maßgeblich sind. Das zum Ätzen eingesetzte Plasma kann auf relativ niedrigen Temperaturen in der Größenordnung bis etwa 250°C und bei geringen Drucken im Bereich von 0,005 bis 20 Torr (etwa 0,006 bis 27 mbar) gehalten werden. Die Plasma-Bestandteile sind überwiegend freie Radikale, die die intensive Reaktivität des Plasmas bewirken. Die Ionenbesetzung in einem Plasma von niedriger Temperatur beträgt größenordnungsmäßig etwa 1% der Bestandteile. In dem Artikel "A Survey of Plasma-Etching Processes", von Richard L. Bersin, veröffentlicht in der Zeitschrift Solid State Technology, Mai 1976, Seiten 31 bis 36 ist sehr eingehend, das Plasmaätzen sowie dessen Anwendung auf halbleitende Materialien behandelt. Ein solcher Prozeß wurde auch bereits eingesetzt, um Gräben oder Öffnungen in Silicium-Halbleiterkörpern auszubilden, vgl. z.B. die US—Patentschriften 3 966 577 (A. K. Hochberg), 4 104 086 (J. A. Bondur sowie 4 139 442 (J. A. Bondur u.a.). Weitere Einzelheiten über die Technologie des reaktiven Ionenätzens bzw. Plasmaätzens können der DE—Offenlegunsschrift 26 17 483 (J. N. Harvilchuck u.a.) entnommen werden. Das von Harvilchuck angegebene HF-induzierte Plasma benutzt als Bestandteil reaktives Chlor, Brom oder Jod. In der zuletzt genannten Schrift findet sich auch eine nähere Beschreibung der HF-Entladekammer zur Durchführung des Verfahrens sowie der einzelnen Prozeßbedingungen.

Anstelle von Metallen, z.B. Aluminium, Aluminium-Kupfer usw., wurde auch bereits dotiertes polykristallines Silicium für die Herstellung Ohm'scher Kontakte zu Siliciumbereichen eingesetzt, vgl. auch die US—Patentschriften 3 664 896, 3 978 515 sowie die europäische Patentanmeldung 78 100 830 (EU—A—1550). Als weitere Literaturstellen werden in diesem Zusammenhang gennant die Tagungszusammenfassung der ISSCC-Tagung vom 18. Februar 1977, Seiten 196/197, "100 PS bipolar logic" von T. Sakai u.a. sowie die Veröffentlichung im IBM Technical Disclosure Bulletin Vol. 19, No. 12, Seite 77. Neben dem Einsatz von polykristallinem Silicium für die Herstellung der elektrischen Verbindungen ist es weiterhin bekannt, dotiertes polykristallines Silicium als Quellschicht für die Dotierung entsprechender Gebiete in einem einkristallinen Siliciumkörper einzusetzen. Die polykristalline Siliciumschicht kann später entweder entfernt oder als Teil des jeweiligen Bauelements belassen werden. Als zugehörige Literatur in diesem Zusammenhang kann beispielsweise verwiesen werden auf die US-Patentschriften 3 978 515, 3 502 517 sowie den Aufsatz "Polycristalline Silicon as a Diffusion Source and Interconnect Layer in I²L Realizations", von Jan Middelhoek u.a., veröffentlicht im IEEE Journal of Solid-State Circuits, Vol. SC—12, No. 2, April 1977, Seiten 135 bis 138. Ein Verfahren gemäß dem ersten Teil des Anspruchs 1, bei dem zunächst auf dem Halbleiterkörperbereiche eine Isolierschicht ausgebildet werden, darauf eine die Oberfläche der Isolierschicht bedeckende Quellschicht der jeweils gewünschten Isolierungsart aufgebracht wird, die Quellschicht partiell geätzt wird und die anordnung einer Eintreib-Wärmebehandlung unterworfen wird, bei der aus den verbliebenen Quellschichtbereichen Dotierstoffe im den Halbleiterkörper diffundieren können ist aus der DE—A—2 818 090 bekannt.

Die Erfindung, wie sie in den Ansprüchen gekennzeichnet ist, löst die Aufgabe, den Anwendungsbereich konventionell ausgestalteter Lithographieverfahren zu weiter verringerten Abmessungen bis hin in den Submikrometerbereich auszuweiten, um Dotierungsgebiete von außerordentlich kleinen Abmessungen zum Aufbau hochintegrierter Schaltkreise herzustellen.

Zusammengefaßt wird dazu im Rahmen der Erfindung zunächst durch Aufbringen und Formen von Isolierschichtbereichen auf einem Halbleiterkörper eine im wesentlichen horizontale und vertikale Oberflächenbereiche aufweisende Oberfläche gebildet. Auf die so beschaffene Oberfläche wird anschließend eine in der gewünschten Dotierungsart dotierte Quellschicht aufgebracht. Unter Ausnutzung der unterschiedlichen Ätzrate in vertikaler und horizontaler Richtung wird mittels reaktivem Ionenätzen die Quellschicht von den horizontalen Oberflächenbereichen abgetragen. Es verbleiben danach lediglich sehr schmale Quellschichtbereiche auf den vertikal gerichteten Oberflächen. Die Bildung der letzlich sehr schmalen Dotierungsgebiete erfolgt schließlich durch eine an sich bekannte Eintrieb-Wärmebehandlung aus den sehr schmalen Quellschichtbereichen. Ihre Breite läßt sich mit der jeweils gewählten Schichtdicke der Quellschicht variieren. Es werden Anwendungen des Verfahrens für den Aufbau von FET- und Bipolar-Halbleiteranordnungen behandelt.

Die Erfindung wird im folgenden anhand von Ausführungsbeispielen unter Zuhilfenahme der Zeichnungen näher erläutert.

Es zeigen:
Fign. 1A bis 1D: ein erstes Ausführungsbeispiel, um in einem Halbleiterkörper Diffusionsgebiete mit sehr sehr kleinen Abmessungen auszubilden;
Fign. 2A bis 2E: ein zweites Ausführungsbeispiel, mit dem eine doppeltdiffundierte integrierte FET-Schaltung aufgebaut werden kann;
Fign. 3A bis 3F: ein drittes Ausführungsbeispiel, mit dem eine integrierte Bipolarschaltung hergestellt wird und
Fign. 4A bis 4D: ein viertes Ausführungsbeispiel der Erfindung, mit dem eine Bipolarschaltung vom Typ der integrierten Injektionslogik aufgebaut wird.

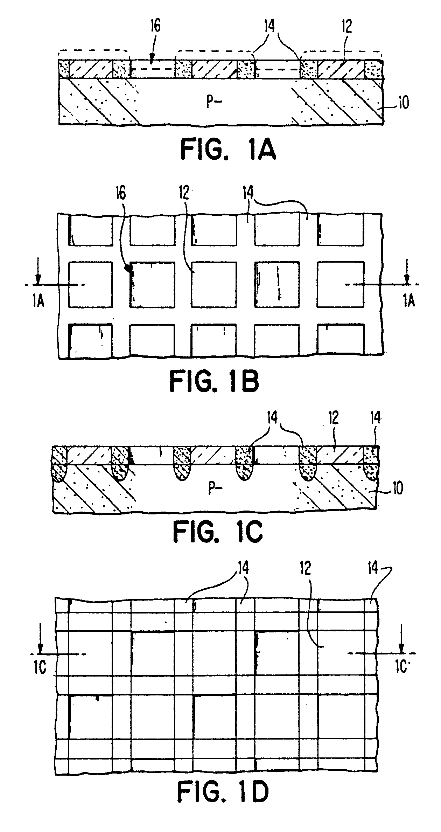

Anhand der Fign. 1A bis 1D soll auf die grundsätzlichen Verfahrensschritte gemäß einer Ausführungsform der Erfindung eingegangen werden. Fig. 1A zeigt in starker Vergrößerung einen kleinen Ausschnitt aus einem Siliciumkörper, in dem mit hoher Packungsdichte der jeweilige integrierte Schaltkreis hergestellt werden soll. Dazu wird von einem einkristallinen, z.B. P-leitenden Siliciumsubstrat 10 ausgegangen, auf dessen einer Hauptoberfläche eine Isolierschicht 12 gebildet ist. Für das Siliciumsubstrat 10 kann natürlich auch ein anderer Leitungstyp gewählt werden. Die mit 12 bezeichnete Schicht kann sich aus einer Vielzahl von Materialien oder Kombinationen daraus zusammensetzen, wozu Siliciumdioxid, Siliciumnitrid, Aluminiumoxid und dergleichen gehören. Diese erste isolierende Schicht 12 wird in der in Fig. 1A gezeigten Weise teilweise entfernt, wozu vorzugsweise ein reaktives Ionenätzverfahren der in der eingangs genannten Literatur näher beschriebenen Art eingesetzt werden kann. Die jeweilige Prozeßatmosphäre hängt dabei von dem jeweils zu behandelnden Material der Isolierschicht ab, vgl. insoweit den ebenfalls eingangs angegebenen Aufsatz "A Survey of Plasma-Etching Processes" von Richard L. Bersin. Auf die Oberfläche wird dann eine zweite Schicht aufgebracht. Diese zweite Schicht kann aus einem Isoliermaterial, aus polykristallinem Silicium oder dergleichen bestehen und ist hochdotiert mit einem P+ Dotiermittel, z.B in diesem Beispielsfall mit Bor. Die zweite Schicht wird auf die als Ergebnis des vorher genannten Ätzprozesses der ersten Isolierschicht 12 vorliegende Oberfläche aufgebracht, die im wesentlichen horizontale sowie im wesentlichen vertikale Oberflächenbereiche aufweist. Die daraus resultierende Struktur wird einem reaktiven Ätzverfahren unterworfen, das auf die zweite Isolierschicht zugeschnitten ist. Dabei werden die auf den horizontalen Oberflächenbereichen (in unterbrochenen Linien angedeutet) liegenden Schichtbereiche der zweiten Schicht entfernt und die im wesentlichen vertikalen Oberflächenbereiche praktisch nicht angegriffen. Als Ergebnis des reaktiven Ionenätzverfahrens (Fig. 1A) verbleiben lediglich schmale Quellschichtbereiche 14 der zweiten Schicht auf den vertikal ausgerichteten Oberflächen. Die Öffnungen sind mit 16 bezeichnet. Fig. 1B zeigt eine Draufsicht zu Fig. 1A, wobei die Schnittlinie für den Querschnitt gemäß Fig. 1A ebenfalls angegeben ist.

Im nächsten Verfahrensschritt werden die P+ Dotierungsstoffe aus den schmalen vertikal ausgerichteten Quellschichtbereichen 14 mittels thermischer Diffusion in das P-Substrat 10 eingebracht. Die mit 12 und 14 bezeichneten Schichten können dann vorzugsweise für die weitere Verarbeitung entfernt werden. Das Ergebnis nach der genannten Diffusion ist in Fig. 1C dargestellt, wibei die Dotierungsgebiete beispielsweise als Kanalstopper für MOS-FET-Schaltungen dienen können. Das so erzeugte Diffusionsmuster kann ferner auch für die Isolation mittels gesperrter Halbleiterübergänge zwischen Bipolarstrukturen eingesetzt werden, die in an sich bekannter Weise anschließend in den derart abgegrenzten Bereichen aufgebaut werden können. Fig. 1D zeigt wieder eine Draufsicht auf die soweit hergestellte Halbleiteranordnung, wobei die Schnittlinie für den in Fig. 1C gezeigten Querschnitt mit angegeben ist. Es ist ersichtlich, daß das Isolationsmuster ein schachbrettartiges Muster ist; natürlich sind auch andere Isolationsmuster mit dem genannten Verfahren herstellbar.

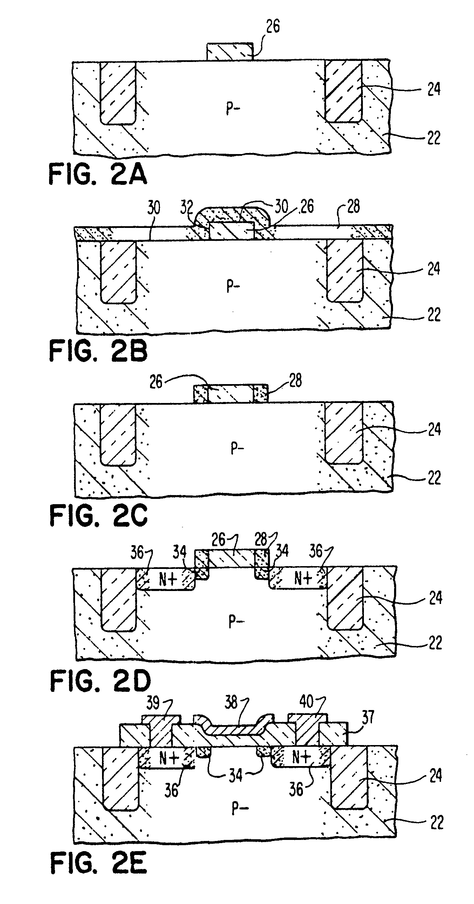

Anhand der Fign. 2A bis 2E soll auf ein Anwendungsbeispiel des Verfahrens zur Herstellung einer doppeltdiffundierten Feldeffekttransistorstruktur mit einem kurzen Kanal und einem flachen Dotierungsprofil eingegangen werden. Fig. 2A zeigt wieder in starker Vergrößerung einen kleinen Ausschnitt aus einem einkristallinen Siliciumkörper, in dem mit hoher Packungdichte ein solcher doppeltdiffundierter FET-Schaltkreis eingebracht werden soll. Ausgegangen wird von einem P— leitenden Substrat 22 mit einer kristallographischen

<100>-Orientierung und einem spezifischen Widerstandswert in der Größenordnung von 1 bis 20 $\Omega \cdot cm$. Zur Isolierung einkristalliner Bereiche im Substrat 22 sind mit 24 bezeichnete Zonen vorgesehen. Dabei kann es sich um teilweise oder vollständige dielektrische Isolationszonen handeln, wobei als dielektrische Materialien Siliciumdioxid, Siliciumnitrid, Glas usw. verwendbar sind. Für hochintegrierte Schaltungen wird vorzugsweise eine teilweise dielektrische Isolation der in Fig. 2A gezeigten Form eingesetzt. Zur Bildung dieser Isolationsgebiete gibt es viele Möglichkeiten, vgl. vorzugsweise die in der eingangs genannten US-Patentschrift 4 104 086 im Detail beschriebenen Methode.

Mittels thermischer Oxidation oder durch chemisches Niederschlagen aus der Gasphase wird anschließend eine Siliciumdioxidschicht 26 von etwa 500 nm Dicke aufgebracht. Zum thermischen Aufwachsen wird eine Sauerstoff- oder Sauerstoff/Wasserdampfatmosphäre bei etwa 970°C eingesetzt. Für die Bildung mittels chemischem Niederschlag wird eine Prozeßatmosphäre aus $SiH_4$, $O_2$ bei etwa 450°C oder $SiH_2Cl_2$, $N_2O$ bei etwa 800°C und Atmosphärendruck oder niedriger eingesetzt. Statt der Siliciumdioxidschicht können auch andere Isolierschichten oder Kombinationen daraus vorgesehen werden.

Mittels standardmäßiger Photolithographie- und Ätzverfahren werden in der ersten Isolierschicht 26 Öffnungen hergestellt. Alternativ läßt sich dazu auch ein reaktives Ionenätzen einsetzen. Die Öffnungen in der Schicht 26 werden an den für Source und Drain der doppeltdiffundierten FET-Strukturen vorgesehenen Stellen geöffnet.

Auf die somit vorliegenden im wesentlichen horizontalen Oberflächenbereiche 30 sowie die vertikalen Oberflächenbereiche 32 wird anschließend eine zweite Schicht 28 aufgebracht. Im vorliegenden Ausführungsbeispiel bestehe diese Schicht 28 aus chemisch niedergeschlagenem Siliciumdioxid entsprechend dem zuvor beschriebenen Verfahren oder aus polykristallinem Silicium. Die mit 28 bezeichnete Schicht sei stark P+ dotiert. Eine zweckmäßige Schichtdicke des Siliciumdioxids liegt zwischen etwa 50 und 2000 nm, vorzugsweise bei 400 nm. Ist die Schicht dicker als 2000 nm, treten Ladungstransportprobleme sowie längere Ätzzeiten auf. Bei einer Schichtdicke <100 nm, besteht die Gefahr von Kurzschlüssen. Die in Fig. 2B gezeigte Struktur wird dann in eine geeignete Prozeßatmosphäre zum reaktiven Ionenätzen des Materials der mit 28 bezeichneten Schicht eingebracht. Dabei werden im wesentlichen die horizontalen Bereiche der Schicht 28 entfernt, so daß die schmalen Quellschichtbereiche 28 entsprechend Fig. 2C verbleiben.

Zur Bildung der mit 36 (Fig. 2D) bezeichneten Gebiete werden durch die Source- und Drain-Öffnungen N+ Ionen eindiffundiert. Dazu kann entweder ein thermisches Diffusions-verfahren oder eine Ionenimplantation mit Phosphor, Arsen oder Antimon oder dergleichen als N Dotierungsstoff eingesetzt werden. Während des im Rahmen der Ionenimplantation oder thermischen Diffusion vorgesehenen sog. Eintreibschritts diffundieren P+ Dotierungsstoffe aus der verbliebenen schmalen Quellschichtbereichen 28 in das Substrat 22, so daß auf diese Weise mit Hilfe der eingetriebenen Begrenzungsgebiete 34 der sehr schmale P Kanalbereich definiert wird. Das N+ Dotierungsgebiet 36 erstreckt sich dabei vorzugsweise tiefer in das Substrat als ein derartiges Begrenzungsgebiet 34. Die resultierende Struktur ist in Fig. 2D dargestellt. Als bevorzugte physikalische Abmessungen der Struktur-gilt für ein P Begrenzungsgebiet 34 eine Breite von ungefähr 500 nm bei einer Tiefe von etwa 200 nm und für ein derartiges N+ Gebiet 36 eine Tiefe von etwa 300 nm.

Für die Fertigstellung der FET-Struktur können zunächst die mit 26 und 28 bezeichneten Schichten entfernt werden. Dann wird eine mit 37 bezeichnete Siliciumdioxidschicht aufgewachsen, wozu vorzugsweise ein Niedrigtemperaturprozeß eingesetzt wird, z.B. ein chemisches Niederschlagen aus der Gasphase der oben beschriebenen Art oder ein thermischer Oxidationsprozeß. Es wurde festgestellt, daß in einer trokkenen Sauerstoffatmosphäre bei 800 oder 900°C das Oxidwachstum auf einem mit Phosphor stark N+ dotierten Gebiet schneller erfolgt und eine wesentlich dickere Oxidschicht ergibt als auf einem Leicht N oder P dotierten Bereich. Ein solches Verfahren ist beispielsweise beschrieben im Aufsatz "Thermal Oxidation of Heavily Phosphorus-Doped Silicon" von C. P. Ho u.a., veröffentlicht im J. Electrochem. Society, Solid State Science and Technology vom April 1978 auf den Seiten 665 bis 671. Aus einem solchen Verfahren resultiert somit über den N+ Bereichen eine dickere Schicht aus Siliciumdioxid als über den P Bereichen, vgl. Fig. 2E. In diesem Verfahren ist eine sog. Halb-Selbstjustierungs-technik zu sehen. Die Gate-Elektrode 38 sowie die Source-und Drain-Anschlüsse 39 und 40 werden gebildet, indem man zunächst eine durchgehende leitfähige Schicht aufbringt, z.B. aus Aluminium, und nachfolgend in an sich bekannter Weise formätzt.

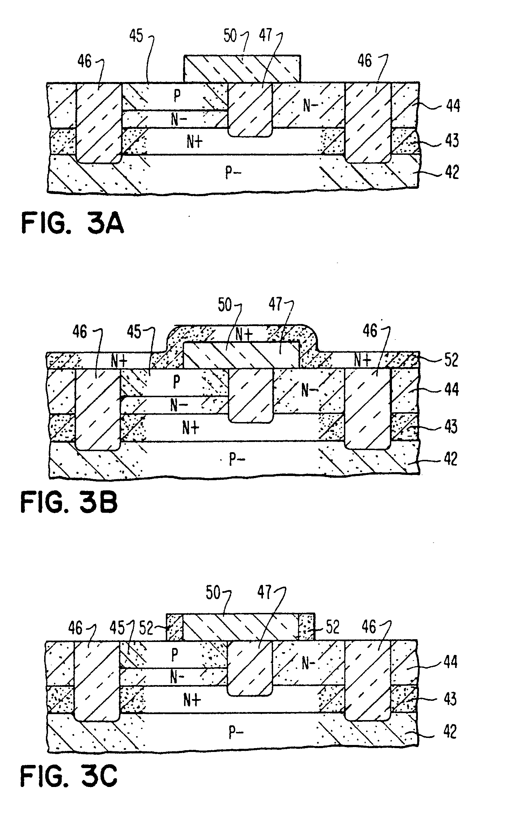

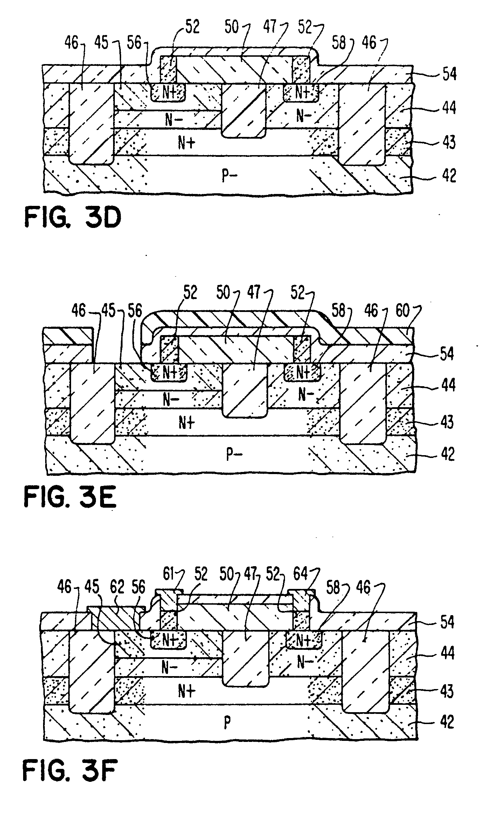

Anhand der Fign. 3A bis 3F soll im folgenden auf ein Ausführungsbeispiel der Erfindung zur Herstellung einer integrierten Schaltung in Bipolartechnik mit sehr kleinflächigen Emittern eingegangen werden. Fig. 3A zeigt wieder in starker Vergrößerung einen kleinen Ausschnitt aus dem betreffenden Siliciumkörper, in dem ein solcher Bipolar-Schaltkreis gebildet werden soll. Soweit in diesem Ausführungsbeispiel NPN Transistoren hergestellt werden, können in gleicher Weise PNP Transistoren bei entsprechend geänderter Wahl der Leitfähigkeitstypen hergestellt werden. In einem P— Substrat 42 aus einkristallinem Silicium ist eine durchgehende N+ Dotierung für einen Subkollektor 43 vorgesehen. Darauf befindet sich eine N— Epitaxieschicht 44. Bei den insoweit betroffenen Prozeßschritten handelt es sich um in der Bipolartechnologie übliche Prozeßschritte. Das Substrat weist in typischen Fällen eine kristallographische <100>-Orientierung sowie einen spezifischen Widerstandswert in der Größenordnung von 1 bis 20 $\Omega \cdot$ cm auf. Die Subkollektordiffusion erfolgt unter Einsatz von Arsen mit einer Oberflächenkonzentration von etwa $10^{20}/cm^3$ über 100 min. bei 1200°C.

Der Schritt zur Herstellung der Epitaxieschicht 44 ist konventionell ausführbar, z.B. unter Verwendung von $SiCl_4/H_2$-oder $SiH_4/H_2$-Gemischen bei Temperaturen von 1000 bis 1200°C. Während der Bildung der Epitaxieschicht wandern die in der N+ Schicht enthaltenen Dotierungsstoffe in die Epitaxieschicht. Die Dicke der Epitaxieschicht weist für hochintegrierte Schaltkreise Werte von etwa $\leqslant 3\ \mu m$ auf. Auf der Oberfläche der Epitaxieschicht wird z.B. mittels thermisch aufgewachsenem Siliciumdioxid eine (nicht dargestellte) Maske aufgebracht, in der durch geeignete Photolithographie- und Ätzverfahren Maskenfenster an den für die dielektrische Isolation der einkristallinen Siliciumbereiche sowie der Basis/Emitter- und Kollektoranschlußgebiete vorgesehenen Stellen geöffnet werden. Die in Fig. 3A mit 46 bezeichneten Isolationsgebiete trennen die einkristallinen Siliciumbereiche gegeneinander; mit 47 ist ein Trenngebiet bezeichnet, das einen Basis/Emitterbereich von einem Kollektoranschlußbereich trennt. Zur Ausbildung dieser dielektrischen Gebiete stehen viele Möglichkeiten zur Verfügung, vorzugsweise wird der bereits oben erwähnte und in der US-Patentschrift 4 104 086 näher beschriebene Prozeß eingesetzt. Dabei werden mittels reaktivem Ionenätzen durch die Maskenöffnungen zunächst Vertiefungen geätzt, die anschließend mit Siliciumdioxid zur Fertigstellung der mit 46 und 47 bezeichneten Bereiche aufgefüllt werden.

Die Oberfläche dieser Anordnung wird anschließend mit einer Maskierungsschicht aus Siliciumdioxid bedeckt, in der mittels üblicher Photolithographie- und Ätzverfahren Öffnungen an den für die Basisgebiete vorgesehenen Stellen freigelegt werden. Dann wird ein P leitendes Basisgebiet 45 mittels Ionenimplantation oder thermischer Diffusion mit einer Oberflächenkonzentration von etwa $5.10^{19}/cm^3$ über 40 Minuten bei etwa 925°C erzeugt.

Anschließend wird alles Siliciumdioxid von der Oberfläche der Anordnung entfernt. Eine Isolierschicht 50, z.B. aus thermisch aufgewachsenem Siliciumdioxid, wird dann auf die Oberfläche des Halbleiterkörpers aufgebracht, wobei sich die dielektrischen Bereiche 46 und 47 ebenfalls bis zu dieser Oberfläche erstrecken. Diese Isolierschicht kann wieder aus irgendeinem geeigneten Isoliermaterial der in den übrigen Ausführungsbeispielen genannten Art bestehen. Mittels standardmäßiger Lithographie- und Ätzverfahren werden in dieser Schicht 50 Fenster an den für die Emitter und Kollektoranschlußgebiete vorgesehenen Stellen geöffnet. Auch dazu kann ein reaktives Ionenätzen eingesetzt werden. Die derart geätzte Isolierschicht 50 weist im wesentlichen horizontale sowie im wesentlichen vertikale Oberflächenbereiche auf. Eine zweite Schicht 52 aus einem Isoliermaterial, aus polykristallinem Silicium oder dergleichen, die stark N+ dotiert ist, wird auf die Oberfläche der insoweit hergestellten Anordnung aufgebracht. In diesem Ausführungsbeispiel wird eine polykristalline Siliciumschicht vorgezogen. Sie wird aufgebracht mittels chemischen Niederschlags aus der Gasphase, wobei beispielsweise ein Gemisch aus Silan und einem den Leitungstyp verändernden (P oder N) Dotierungsstoff in einer Wasserstoff enthaltenden Atmosphäre bei einer Temperatur im Bereich von 500 bis 1000°C verwendet wird. Alternativ dazu kann auch das polykristalline Silicium zunächst (undotiert) aufgebracht und erst anschließend mittels Ionenimplantation dotiert werden. Die Dicke der zweiten Isolierschicht liegt zweckmäßig zwischen etwa 100 und 1000 nm, vorzugsweise bei 400 nm. Durch die Dicke dieser Schicht wird die Größe der Emitterfläche sowie die Breite der Kollektoranschlußgebiete festgelegt. Die somit vorliegende Anordnung entsprechend Fig. 3B wird dann in eine reaktive Ätzatmosphäre für polykristallines Silicium eingebracht. Dabei wird die mit 52 bezeichnete Schicht entsprechend Fig. 3C von allen horizontalen Oberflächenbereichen abgetragen. Dann wird eine Siliciumdioxidschicht thermisch bei etwa 970°C in einer Sauerstoff-oder Sauerstoff/Wasserdampfatmosphäre auf der Siliciumoberfläche zur Bildung der mit 54 bezeichneten Schicht aufgewachsen. Die in Fig. 3D dargestellte Struktur wird über etwa 100 bis 300 Minuten einer Temperatur im Bereich von etwa 1000 bis 1100°C ausgesetzt, um die N+ Dotierungsstoffe von den verbliebenen schmalen Quellschichtbereichen 52 zur Bildung des Emitters 56 in das P Basisgebiet 45 bzw. zur Bildung des Kollektoranschlußgebiets 58 in das zugehörige N- Gebiet einzutreiben.

Anschließend wird eine sog. Block-out-bzw. Grobmaskierung 60 aus einem geeigneten Photolack aufgetragen, belichtet und entwickelt, um in der Siliciumdioxidschicht 54 eine Öffnung zum Basisgebiet 45 herzustellen. Die mit 60 bezeichnete Schicht wird darauf wieder entfernt. Die Siliciumdioxidschicht 54 wird bis auf die polykristalline Siliciumschicht 52 hinunter abgetragen und diese Schicht 52 wird teilweise oder bis hinunter auf die Siliciumgebiete 56 und 58 entfernt. Emitter-, Basis- bzw. Kollektoranschlüsse 61, 62 und 54 werden schließlich ausgebildet, indem mittels üblicher Verfahren eine Leitschicht aufgebracht und in dem jeweils gewünschten Muster formgeätzt wird. Alternativ können das Basiskontaktloch sowie die Kontaktlöcher für Emitter und Kollektoranschlußgebiet auch ggf. mit einem einzigen Maskierungsschritt ausgebildet werden.

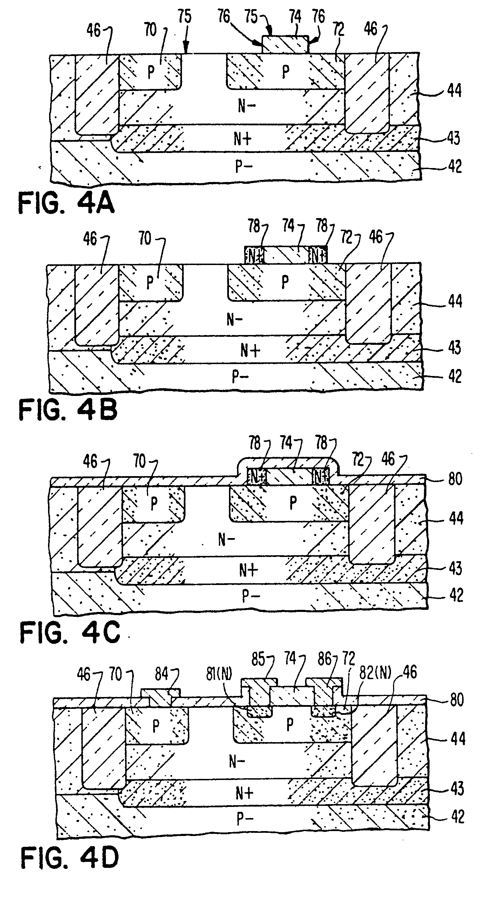

Anhand eines in den Fign. 4A bis 4D dargestellten letzten Ausführungsbeispiels soll auf die Anwendung der Erfindung zur Herstellung einer integrierten Injektionslogikschaltung in Bipolartechnologie eingegangen werden. Fig. 4A zeigt wieder in starker Vergrößerung einen kleinen Ausschnitt aus einem Siliciumkörper, in dem die Schaltung gebildet werden soll. Die in Fig. 4A gezeigte Halbleiteranordnung wird in ähnlicher Weise, wie für Fig. 3A beschrieben, hergestellt, wobei weitgehend gleich Bezugszeichen verwendet sind. Anstatt eines P Basisgebiets sind nun in zumindest einigen der dielektrisch isolierten einkristallinen Siliciumbereiche zwei P Gebiete 70 und 72 vorgesehen. Mittels thermischer Oxidation oder durch chemischen Niederschlag ist eine Isolierschicht 74 auf den Halbleiterkörper aufgebracht. Diese Schicht kann aus einem oder einer Kombination verschiedener Isoliermaterialien der oben erwähnten Arten bestehen. Mittels standardmäßiger Lithographie- und Ätzverfahren, einschließlich reaktivem Ionenätzen, werden in der Schicht 74 Öffnungen ausgebildet. Dabei bleibt die Schicht 74 in der in Fig. 4A bezeichneten Weise über einem Teilbereich eines der P Gebiete stehen. Es ergibt sich somit bezüglich der Schicht sowie des Substrats eine Oberfläche mit horizontalen sowie vertikalen Oberflächenbereichen 75 bzw. 76. Eine zweite Schicht 78 aus einem Isoliermaterial, aus polykristallinem Silicium oder dergleichen, die stark N+ dotiert ist, wird auf dieser so geformten Oberfläche aufgebracht. Im Rahmen dieses Ausführungsbeispiels wird eine Schicht aus polykristallinem Silicium vorgezogen. Die Bildung dieser polykristallinen Siliciumschicht erfolgt wieder mittels chemischen Niederschlags aus der Gasphase entsprechend dem beispielsweise anhand der Fign. 3A bis 3F beschriebenen vorhergehenden Ausführungsbeispiel. Gleiches gilt für die Dicke der zweiten Isolierschicht, durch die die Größe der für die gewünschten N Gebiete maßgeblichen Öffnungen festgelegt wird. Die soweit prozessierte Halbleiteranordnung wird anschließend in eine Prozeßatmosphäre zum reaktiven Ionenätzen des polykristallinen Siliciums eingebracht. Dabei wird die mit 74 bezeichnete Schicht im wesentlichen von allen horizontalen Oberflächenbereichen abgetragen, jedoch auf den vertikalen Oberflächenbereichen entsprechend Fig. 4B belassen. Anschließend wird eine mit 80 bezeichnete Schicht aus Siliciumdioxid in der früher beschriebenen Weise auf die Siliciumoberfläche aufgewachsen. Die in Fig. 4C dargestellte Struktur wird 100 bis 300 Minuten lang auf etwa 1000 bis 1100°C aufgeheizt. um die N+ Dotierungsstoffe aus den verbliebenen Bereichen der Schicht 78 in das P Gebiet 72 zur Bildung der N Gebiete 81 und 82 eindringen zu lassen. Die Anschlüsse der derart hergestellten integrierten Injektionslogikschaltung werden in an sich bekannter Weise durch Ausbilden einer Grobmaskierung und Ätzen des polykristallinen Siliciums mit anschließendem Metallaufdampfen in der oben unter Bezugnahme auf die Fign. 3A bis 3F beschriebenen Weise hergestellt. Die Elektrode 84 kontaktiert dabei das Gebiet 70, Elektrode 85 das Gebiet 81 und Elektrode 86 das Gebiet 82. Auch die mit 44 und 72 bezeichneten Gebiete werden für die Fertigstellung der Schaltung noch mit Elektroden versehen, was jedoch in Fig. 4D nicht mehr gezeigt ist, weil es sich insoweit um konventionelle Maßnahmen handeln kann. Weitere Einzelheiten dieses Schaltkreistyps finden sich im übrigen in der US-Patentschrift 3 736 477.

**Patentansprüche**

1. Verfahren zur Herstellung sehr schmaler Dotierungsgebiete in einem Halbleiterkörper (z.B. 10 in Fig. 1A) unter Ausnutzung einer Diffusion der jeweiligen Dotierstoffe aus zugehörigen Quellschichtbereichen, dadurch gekennzeichnet, daß zunächst auf dem Halbleiterkörper (10) Bereiche einer Isolierschicht (12, 26, 50, 74) derart ausgebildet werden, daß die Isolierschichtbereiche im wesentlichen horizontale sowie im wesentlichen vertikale Oberflächen aufweisen, daß darauf eine die horizontalen und vertikalen Oberflächen der Isolierschichtbereiche (12, 26, 50, 74) bedeckende Quellschicht der jeweils gewünschten Dotierungsart aufgebracht wird, daß diese Quellschicht einem reaktiven Ionenätzverfahren derart unterzogen wird, daß sie von den horizontalen Oberflächen der Isolierschicht (12, 26, 50, 74) abgetragen wird und lediglich schmale Quellschichtbereiche (14, 28, 52, 78) auf den vertikalen Oberflächen der Isolierschicht verbleiben, und daß die Anordnung schließlich in an sich bekannter Weise einer Eintreib-Wärmebehandlung unterworfen wird, bei der die jeweiligen Dotierstoffe zur Bildung schmaler entsprechender Dotierungsgebiete aus den verbleibenen schmalen Quellschichtbereichen (14, 28, 52, 78) in den Halbleiterkörper diffundieren können.

2. Verfahren nach Anspruch 1, dadurch gekennzeichnet, daß vor der Eintreib-Wärmebehandlung die Schichtdicke einiger der schmalen Quellschichtbereiche vermindert wird, um Dotierungsgebiete entsprechend unterschiedlicher Eindringtiefe zu erhalten.

3. Verfahren nach Anspruch 1 oder 2, dadurch gekennzeichnet, daß die Isolierschicht (12) aus Siliciumdioxid und die Quellschicht aus dotiertem polykristallinem Silicium besteht.

4. Verfahren nach einem der Ansprüche 1 bis 3, dadurch gekennzeichnet, daß die Eintreib-Wärmebehandlung in einer oxidierenden Atmosphäre durchgeführt wird.

5. Verwendung des Verfahrens nach einem der Ansprüche 1 bis 4, dadurch gekennzeichnet, daß die derart erzeugten Dotierungsgebiete einkristalline Bereiche des Halbleiterkörpers voneinander isolieren, in welchen dann integrierte FET- oder Bipolarschaltkreise ausgebildet werden (Fign. 1A bis 1D).

6. Verwendung des Verfahrens nach einem der Ansprüche 1 bis 4 zur Herstellung einer Bipolar-Halbleiteranordnung in voneinander vorzugsweise durch dielektrische Isolationsgebiete (46 in Fig. 3A) getrennten einkristallinen Halbleiterbereichen, dadurch gekennzeichnet, daß bei der Eintreib-Wärmebehandlung Dotierungsgebiete (56, 58 in Fig. 3D) gleichzeitig für den Emitter und das Kollektoranschlußgebiet gebildet werden.

7. Verwendung des Verfahrens nach einem der Ansprüche 1 bis 4 zur Herstellung einer Halbleiteranordnung vom Typ der sog. integrierten Injektionslogikschaltungen innerhalb voneinander isolierter einkristalliner Halbleiterbereiche eines ersten Leitungstyps, dadurch gekennzeichnet, daß in einem solchen Halbleiterbereich mindestens zwei beabstandete Dotierungsgebiete (70, 72 in Fig. 4A) vom zweiten Leitungstyp sowie auf der Halbleiteroberfläche über mindestens einem dieser Dotierungsgebiete die Isolierschichtbereiche (74) mit den im wesentlichen horizontalen und im wesentlichen vertikalen Oberflächen (75, 76) gebildet werden, und daß durch eine weitere Behandlung entsprechend Patentanspruch 1 in mindestens einem Dotierungsgebiet (72) vom zweiten Leitungstyp entgegengesetzt dotierte Gebiete (81, 82 in Fig. 4D) aus den zugehörigen schmalen Quellschichtbereichen (78) eindiffundiert werden.

8. Verwendung des Verfahrens nach einem der Ansprüche 1 bis 4 zur Herstellung einer doppeltdiffundierten FET-Halbleiteranordnung, dadurch gekennzeichnet, daß nach der Ausbildung der schmalen Quellschichtbereiche (28 in Fig. 2C) zunächst in die daran angrenzenden Oberflächenbereiche des Halbleiterkörpers (22) die Dotierungen für die Source- und Draingebiete (36 in Fig. 2D) eingebracht werden und darauf mittels der Eintreib-Wärmebehandlung die Diffusion aus den schmalen Quellschichtbereichen (28) zur Bildung an die Source- und Draingebiete angrenzender und entgegengesetzt dotierter Begrenzungsgebiete (34) zur Abgrenzung eines kurzen Kanalbereiches durchgeführt wird.

9. Verwendung nach Anspruch 8, dadurch gekennzeichnet, daß im Fall von N+ leitenden Source- und Draingebieten (36), N leitenden Begrenzungsgebieten (34) und einem P leitenden Halbleiterkörper (22) nach dem vollständigen Freilegen der Halbleiteroberfläche für die Bildung des Gate- sowie Felddielektrikums die in unterschiedlichen Schichtdicken resultierende verschiedene thermische Aufwachsgeschwindigkeit einer Siliciumdioxidschicht über dem jeweiligen Halbleitermaterial ausgenutzt wird (Fig. 2E).

**Revendications**

1. Procédé pour former des régions de dopage très étroites dans un corps semi-conducteur (par exemple 10, sur la figure 1A) en utilisant une diffusion de dopants appropriés à partir de régions de couches de source associées, caractérisé en ce qu'on forme sur le corps semi-conducteur (10) des régions dans une couche isolante (12, 26, 50, 74) de telle sorte que ces régions de couches isolantes présentent des surfaces essentiellement horizontales et essentiellement verticales, en ce qu'on y dépose ensuite une couche de source du type de dopage désiré recouvrant les surfaces horizontales et verticales desdites régions de couches isolantes (12, 26, 50, 74), en ce qu'on soumet cette couche de source à un procédé de décapage par ions réactifs de telle sorte qu'elle soit enlevée des surfaces horizontales de la couche isolante (12, 26, 50, 74) en laissant seulement subsister des régions de couches de source étroites (14, 28, 52, 78) sur les surfaces verticales de la couche isolante, et en ce qu'on soumet ensuite le dispositif de la façon connue à un traitement thermique d'étalement dans lequel lesdits dopants appropriés peuvent diffuser à partir des régions de couches de source étroites subsistantes (14, 28, 52, 78) dans le corps semiconducteur pour former des régions de dopage étroites correspondantes.

2. Procédé selon la revendication 1, caractérisé en ce qu'on diminue l'épaisseur de couche de quelques unes des régions de couche de source étroites avant le traitement thermique d'étalement pour obtenir des régions de dopage de profondeur de pénétration différente.

3. Procédé selon la revendication 1 ou 2, caractérisé en ce que la couche isolante (12) est en dioxyde de silicium et la couche de source est en silicium polycristallin dopé.

4. Procédé selon l'une des revendications 1 à 3, caractérisé en ce que le traitement thermique d'étalement est effectué dans une atmosphère oxydante.

5. Utilisation du procédé selon l'une des revendications 1 à 4, caractérisée en ce que les régions de dopage ainsi formées isolent des régions monocristallines du corps semi-conducteur les unes des autres; des circuits intégrés FET ou bipolaires étant ensuite formés dans ces régions (figures 1A à 1D).

6. Utilisation du procédé selon l'une des revendications 1 à 4 pour fabriquer un dispositif semi-conducteur bipolaire dans des régions semi-conductrices monocristallines isolées les unes des autres de préférence par des régions isolantes diélectriques (46, sur la figure 3A), caractérisée en ce que le traitement thermique d'étalement permet de former des régions de dopage (56, 58 de la figure 3D) simultanément pour l'émetteur et pour la région de contact de collecteur.

7. Utilisation du procédé selon l'une des revendications 1 à 4 pour fabriquer un dispositif semi-conducteur du type de circuits intégrés dit à logique d'injection dans des régions semi-conductrices monocristallines d'un premier type de conductivité, isolées les unes des autres, caractérisée en ce qu'on forme dans une telle région semi-conductrice au moins deux régions de dopage espacées (70, 72 de la figure 4A) du second type de conductivité, et sur la surface semi-conductrice, au-dessus d'au moins une de ces régions de dopage, les régions de couches isolantes (74) avec les surfaces essentiellement horizontales et essentiellement verticales (75, 76) et en ce qu'on utilise un autre traitement défini par la revendication 1, pour diffuser dans au moins une région de dopage (72) du second type de conductivité des régions de dopage opposé (81, 82 de la figure 4D) à partir des régions de couches de source étroites associées (78).

8. Utilisation du procédé selon l'une des revendications 1 à 4 pour réaliser un dispositif semi-conducteur FET à double diffusions, caractérisée en ce que, après avoir formé les régions de couches de source étroites (28 de la figure 2C), on introduit d'abord dans les régions de surface adjacents du corps semi-conducteur (22) le dopages pour les régions de source et de drain (35 de la figure 2D), et en ce qu'on utilise ensuite le traitement thermique d'étalement pour la diffusion à partir des régions de couches de source étroites (28) pour former des régions de limitation (34) présentant des types de dopage opposés, adjacentes aux régions de source et de drain pour définir une région de canal courte.

9. Utilisation selon la revendication 8, caractérisée en ce que, dans le cas de régions de source et de drain (36), de type de conductivité N+, de régions de limitation (34) de type de conductivité N, et d'un corps semi-conducteur (22) de type de conductivité P, on utilise la vitesse de croissance thermique variable d'une couche de dioxyde de silicium qui a pour résultat différentes épaisseurs de couches au-dessus du matériau semi-conducteur respectif après avoir complètement exposé la surface semi-conductrice pour former le diélectrique de porte et de champ (figure 2E).

**Claims**

1. Method of making very narrow doping regions in a semiconductor body (e.g. 10) in Fig. 1A) utilizing a diffusion of the respective dopants of associated source layers, characterized in that first on the semiconductor body (10) regions of an insulation layer (12, 26, 50, 74) are made in such a manner that they have substantially horizontal as well as substantially vertical surfaces, that a source layer of the respective desired dopant is applied thereon covering the horizontal and vertical surfaces of the insulation layers (12, 26, 50, 74), that this source layer is exposed to reactive ion etching in such a manner that it is removed from the horizontal surfaces of the insulation layer (12, 26, 50, 74) and that there merely remain narrow source layers (14, 28, 52, 78) on the vertical surfaces of the insulation layer, and that finally, in a manner known per se, the arrangement is exposed to a heat treatment where in order to form narrow corresponding doping regions the respective dopants are diffused from the remaining narrow source layers (14, 28, 52, 78) into the semi-conductor body.

2. Method as claimed in Claim 1, characterized in that prior to the heat treatment the layer thickness of some of the narrow source layers is reduced to obtain doping regions of a correspondingly different penetration depth.

3. Method as claimed in Claim 1 or 2, characterized in that the insulation layer consists of silicon dioxide, and the source layer of doped polycrystalline silicon.

4. Method as claimed in any one of Claims 1 to 3, characterized in that the heat treatment is effected in an oxidizing atmosphere.

5. Use of the method as claimed in any one of Claims 1 to 4, characterized in that the thus produced doping regions insulate monocrystalline regions of the semiconductor body from each other where integrated FET or bipolar circuits are subsequently formed (Figs. 1A bis 1D).

6. Use of the method as claimed in any one of Claims 1 to 4 for making a bipolar semiconductor arrangement in monocrystalline semiconductor regions preferably separated from each other by dielectric insulation regions (46 in Fig. 3A), characterized in that during the heat treatment doping regions (56, 58) in Fig. 3D are simultaneously formed for the emitter and for the collector reach-through region.

7. Use of the method as claimed in any one of Claims 1 to 4 for making a semiconductor arrangement of the type of the so-called integrated injection logic circuits within monocrystalline semiconductor regions of a first conductivity type insulated from each other, characterized in that in such a semiconductor region at least two spaced doping regions (70, 72 in Fig. 4A) of the second conductivity type, and on the semiconductor surface over at least one of these doping areas the insulation layer regions (74) with the substantially horizontal and substantial vertical surfaces (75, 76) are formed, and that through another process in accordance with patent Claim 1, in at least one doping region (72) of the second conductivity type oppositely doped regions (81, 82) in Fig. 4D are diffused from the associated narrow source layers (78).

8. Use of the method as claimed in any one of Claims 1 to 4 for making double-diffused FET semiconductor arrangement, characterized in that after the forming of the narrow source layers (28 in Fig. 2C) the dopings for the source and drain regions (36 in Fig. 2D) are introduced in the adjacent surface regions of the semiconductor body (22), and that subsequently by means of the heat treatment there follows the diffusion from the narrow source layers (28) to form limiting areas (34) which are adjacent to the source and drain regions and which are oppositely doped, to limit a short channel region.

9. Use in accordance with Claim 8, characterized in that in the case of N+ conductive source and drain regions (36), N-conductive limiting areas (34) and P-conductive semiconductor body (22) after the complete exposure of the semiconductor surface for the forming of the gate and field di-electric, the differing thermal growth speed of a silicon dioxide layer which results in differing layer thicknesses over the respective semiconductor material is utilized (Fig. 2E).

16    14    12

## FIG. 1A

P-    10

16    12    14

1A    1A

## FIG. 1B

14    12    14

P-    10

## FIG. 1C

14    12    14

1C    1C

## FIG. 1D

1

0 010 633

FIG. 2A

FIG. 2B

FIG. 2C

FIG. 2D

FIG. 2E

2

45  50⌐ 47⌐
46⌐

```
        P
        N—
        N+
```

**FIG. 3A**

44
43
42

---

50⌐  47⌐
46⌐  45⌐  N+  46⌐

```
  N+        P        N+      52
           N—
           N+
        P—
```

**FIG. 3B**

44
43
42

---

50⌐  47⌐
46⌐  45⌐ 52  52  46⌐

```
        P
        N—
        N+
      P—
```

**FIG. 3C**

44
43
42

FIG. 3D

FIG. 3E

FIG. 3F

FIG. 4A

FIG. 4B

FIG. 4C

FIG. 4D